# EUROPEAN PATENT SPECIFICATION

(11) **EP 0 949 812 B1**
(45) Date of publication and mention of the grant of the patent: **27.11.2002**
(21) Application number: 99302785.3
(22) Date of filing: 09.04.1999
(51) Int. Cl.: H03G 3/20, H04N 5/52

(54) **Automatic gain control apparatus**
Gerät zur automatischen Verstärkungsregelung
Appareil de commande automatique de gain

(30) Priority: 10.04.1998 JP 9873898
(43) Date of publication of application: 13.10.1999
(73) Proprietor: ALPS ELECTRIC CO., LTD., Ota-ku Tokyo 145 (JP)
(72) Inventor: Yamagata, Yuichiro, Soma-shi, Fukushima-ken (JP)
(74) Representative: Kensett, John Hinton

(56) References cited:
- US-A- 4 403 346
- US-A- 4 438 529
- US-A- 4 558 289
- PATENT ABSTRACTS OF JAPAN vol. 007, no. 021 (E-155), 27 January 1983 & JP 57 180216 A (SANYO DENKI KK;OTHERS: 01), 6 November 1982
- PATENT ABSTRACTS OF JAPAN vol. 004, no. 145 (E-029), 14 October 1980 & JP 55 096709 A (HITACHI LTD), 23 July 1980
- PATENT ABSTRACTS OF JAPAN vol. 014, no. 248 (E-0933), 28 May 1990 & JP 02 069083 A (SONY CORP), 8 March 1990

## Description

The present invention relates to gain control for a VHF tuner section which receives a digital audio broadcasting signal of a VHF band and a UHF tuner section which receives a digital audio broadcasting signal of a UHF band in a digital audio broadcasting receiver which receives a digital audio broadcasting signal.

In Europe, digital audio broadcasts using a frequency of a VHF band or a UHF band have been made practical. Since frequencies of the VHF band or the UHF band are already being used for television broadcasts, frequencies commonly referred to as "vacant channels", which are not used for television broadcasts, are used for digital audio broadcasts.

In the receiver which receives this digital audio broadcast, due to differences in frequency, a VHF tuner section is used which receives a broadcasting signal of a VHF band and a UHF tuner section is used which receives a broadcasting signal of a UHF band. Since these tuner sections are designed so as to obtain various characteristics, such as gain, noise factor, or distortion, at a predetermined or higher level in each frequency, characteristics regarding gain control are different.

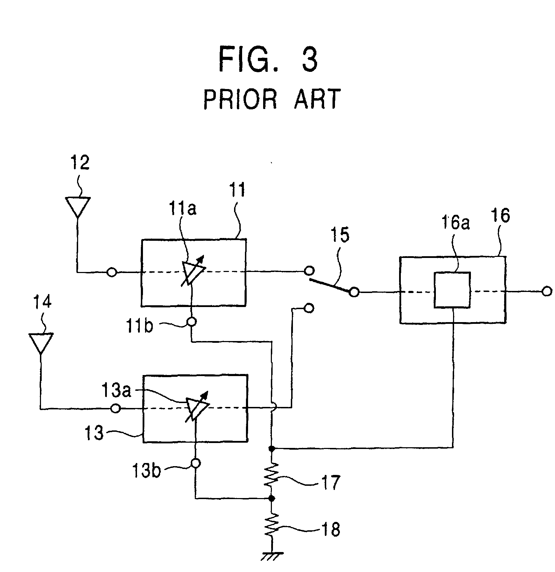

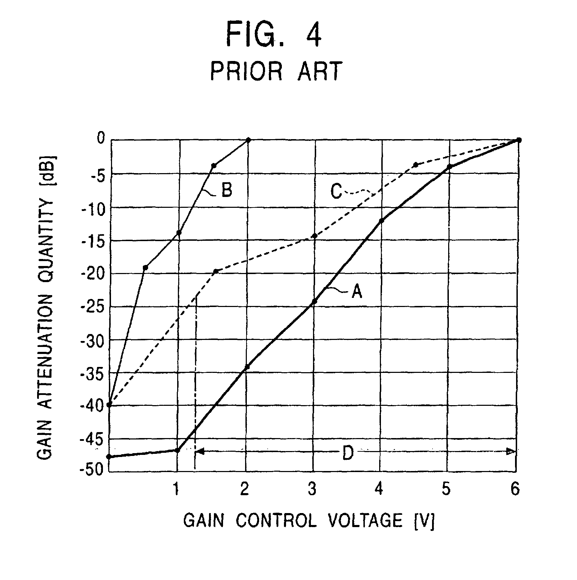

A conventional digital audio broadcasting receiver is described with reference to Figs. 3 and 4. Here, Fig. 3 is a block diagram illustrating the construction of a conventional gain control circuit. Fig. 4 is a characteristic view illustrating gain control characteristics of the gain control circuit shown in Fig. 3.

Referring first to Fig. 3, a VHF tuner section 11, which is connected to a VHF antenna 12, receives a digital audio broadcasting signal of a VHF band and outputs an intermediate-frequency signal IFv. In a similar manner, a UHF tuner section 13, which is connected to a UHF antenna 14, receives a digital audio broadcasting signal of a UHF band and outputs an intermediate-frequency signal IFu. One of the intermediate-frequency signal IFv output from the VHF tuner section 11 and the intermediate-frequency signal IFu output from the UHF tuner section 13 is selected by a switch 15, and is input to an intermediate-frequency circuit section 16. The intermediate-frequency circuit section 16 comprises a gain control voltage generation circuit 16a which generates a gain control voltage Vagc corresponding to the level of the input intermediate-frequency signal IFv or IFu. That is, when the level of the input intermediate-frequency signal IFv or IFu is very low or when neither the intermediate-frequency signals IFv nor IFu is input, a maximum gain control voltage Vmax (for example, 6 V (volts)) is generated, and the gain control voltage Vagc decreases with an increase in the level of the input intermediate-frequency signal IFv or IFu.

A minimum value Vmin of the gain control voltage Vagc output by the gain control voltage generation circuit 16a is usually about 1 to 1.2 V due to a residual voltage possessed by the gain control voltage generation circuit 16a itself.

The intermediate-frequency circuit section 16 comprises a demodulation circuit (not shown) which demodulates the intermediate-frequency signal IFv or IFu and outputs an audio signal A.

The VHF tuner section 11 comprises a tuning circuit (not shown) for selecting a digital audio broadcasting signal, which is desired to be received, from the input digital audio broadcasting signals of the VHF band, a gain control amplifying circuit 11a, and a mixer (not shown). The selected digital audio broadcasting signal of the VHF band is frequency-converted into an intermediate-frequency signal IFv by the mixer. Furthermore, the VHF tuner section 11 comprises a gain control end 11b, so that the gain control voltage Vagc output from the intermediate-frequency circuit section 16 is input to this gain control end 11b. thereby controlling the gain of the gain control amplifying circuit 11a.

In contrast, the UHF tuner section 13 comprises a tuning circuit (not shown) for selecting a digital audio broadcasting signal, which is desired to be received, from the input digital audio broadcasting signals of the UHF band, a gain control amplifying circuit 13a, and a mixer (not shown). The selected digital audio broadcasting signal of the UHF band is frequency-converted into an intermediate-frequency signal IFu by the mixer. Furthermore, the UHF tuner section 13 comprises a gain control end 13b, so that the gain control voltage Vagc output from the intermediate-frequency circuit section 16 is input to this gain control end 13b, thereby controlling the gain of the gain control amplifying circuit 13a.

As a result, control is performed so that the level of the intermediate-frequency signal IFv or IFu input to the intermediate-frequency circuit section 16 becomes nearly constant.

Here, referring to Fig. 4, a description is given of the gain control characteristics of the gain control amplifying circuit 11a of the VHF tuner section 11 and the gain control amplifying circuit 13a of the UHF tuner section 13. First, a curve A in Fig. 4 shows the gain control characteristics of the gain control amplifying circuit 11a of the VHF tuner section 11. The gain control amplifying circuit 11a is designed in such a way that its maximum gain (the maximum gain is indicated by 0 dB as a reference) is obtained when the gain control voltage (horizontal axis) applied to the gain control end 11b is 6 V. The gain is attenuated as the gain control voltage is gradually decreased, and a gain of about 47 dB at a maximum is attenuated when the gain control voltage is 1 V. The gain attenuation quantity barely changes under a gain control voltage of 1 V or less.

In contrast, the gain control amplifying circuit 13a of the UHF tuner section 13 is designed in such a way that its maximum gain is obtained when the gain control voltage (horizontal axis) in the gain control end 13b is 2 V, as shown by a curve B in Fig. 4. When the gain control voltage is 0 V, the gain attenuation quantity becomes nearly 40 dB.

In a manner as described above, the gain control characteristics of the gain control amplifying circuit 11a of the VHF tuner section 11 are different from the gain control characteristics of the gain control amplifying circuit 13a of the UHF tuner section 13, and the gain control voltage (2 V) of the gain control amplifying circuit 13a of the UHF tuner section 13, which is required at the maximum gain time, is one-third of the gain control voltage (6 V) of the gain control amplifying circuit 11a of the VHF tuner section 11, which is required at the maximum gain time. Therefore, the gain control voltage Vagc from the intermediate-frequency circuit section 16 is divided and supplied to the gain control end 13b of the UHF tuner section 13.

More specifically, the gain control voltage Vagc is directly supplied to the gain control end 11b of the VHF tuner section 11, and in contrast, the gain control voltage Vagc is divided by resistors 17 and 18 and supplied to the gain control end 13b of the UHF tuner section 13. Here, since the maximum voltage of Vagc is nearly 6 V, in order to obtain the control voltage of 2 V required at the maximum gain time of the gain control amplifying circuit 13a of the UHF tuner section 13, the maximum voltage of Vagc may be divided by 1/3 by the resistors 17 and 18.

As a result, when the gain control voltage Vagc is at a maximum value Vmax (6 V), a gain control voltage of 2 V is supplied to the gain control end 13b. Therefore, the gain control characteristics of the gain control amplifying circuit 13a are seemingly converted into characteristics such as those shown by a curve C in Fig. 4, and when the gain control voltage Vagc is at a maximum value Vmax (6 V), the maximum gain is obtained.

With the above-described construction, when the gain control voltage Vagc output from the gain control voltage generation circuit 16a of the intermediate-frequency circuit section 16 is at maximum, it is possible to cause both the gain control amplifying circuit 11a of the VHF tuner section 11 and the gain control amplifying circuit 13a of the UHF tuner section 13 to operate so as to generate a maximum gain.

In the meantime, the minimum value Vmin of the gain control voltage Vagc output from the gain control voltage generation circuit 16a is, usually, not decreased to less than 1 to 1.2 V due to the residual voltage possessed by the gain control voltage generation circuit 16a itself, and the effective range of the gain control voltage Vagc output from the gain control voltage generation circuit 16a is in a range D shown in Fig. 4.

Consequently, as is clear from Fig. 4, the gain control amplifying circuit 11a of the VHF tuner section 11 can be attenuated to nearly 45 dB (see the curve A), but the gain control amplifying circuit 13a of the UHF tuner section 13 can be attenuated to only nearly 25 dB (see the curve C).

As a result, when the digital audio broadcasting signal of the UHF band is received, even if the level of the received signal is increased, gain control of the UHF tuner section 13 cannot be performed, resulting in a problem in that large distortion occurs in a mixer or the like within the intermediate-frequency circuit section 16.

An automatic gain control apparatus for TV broadcast signals is discussed in PATENT ABSTRACTS OF JAPAN vol. 007, no. 021 (E-155), 27 January 1983 & JP 57 180216 A (SANYO DENKI KK), 6 November 1982.

Accordingly, it is an object of the present invention to provide an automatic gain control apparatus which supplies a common gain control voltage to a plurality of gain control amplifying circuits having different gain control characteristics and which further causes the respective gain control amplifying circuits to be controlled from a maximum gain to a minimum gain in an effective varying range of the gain control voltage.

To achieve the above object, according to the present invention as defined in claim 1, there is provided an automatic gain control apparatus comprising: a first tuner section for receiving a broadcasting signal of a first frequency band and outputting a first intermediate-frequency signal; a second tuner section for receiving a broadcasting signal of a second frequency band and outputting a second intermediate-frequency signal; and a gain control voltage generation circuit to which the first intermediate-frequency signal or the second intermediate-frequency signal is selectively input and which generates a gain control voltage responsive to the intensity of the first or second intermediate-frequency signal, wherein the first tuner section comprises a first gain control amplifying circuit having a first control end for amplifying the broadcasting signal of the first frequency band and for controlling the degree of amplification, the second tuner section comprises a second gain control amplifying circuit having a second control end for amplifying the broadcasting signal of the second frequency band and for controlling the degree of amplification, a control voltage at which the gain of the first gain control amplifying circuit reaches a maximum is set to be higher than a control voltage at which the gain of the second gain control amplifying circuit reaches a maximum, the gain control voltage is input to a voltage-dividing circuit formed of semiconductor two-terminal elements and a resistor, the resistor is grounded, a voltage applied across both ends of the voltage-dividing circuit is applied to the first control end, and a voltage divided by the semiconductor two-terminal elements and the resistor is applied to the second control end.

Furthermore, in the automatic gain control apparatus of the present invention, preferably, the resistor is formed of a first resistor and a second resistor, the second resistor is grounded, and a voltage applied across the second resistor is applied to a second control end.

Furthermore, the automatic gain control apparatus of the present invention may comprise a plurality of diodes in which semiconductor two-terminal elements are connected in series.

The above and further objects, aspects and novel features of the invention will become more apparent from the following detailed description when read in connection with Embodiments of the invention will now be described, by way of example only, with reference to the accompanying drawings, in which;

Fig. 1 is a block diagram of an automatic gain control apparatus according to an embodiment of the present invention.

Fig. 2 is a characteristic view of the gain control characteristics of the automatic gain control apparatus according to the embodiment of the present invention.

Fig. 3 is a block diagram of a conventional gain control apparatus.

Fig. 4 is a characteristic view of the gain control characteristics of the conventional gain control apparatus.

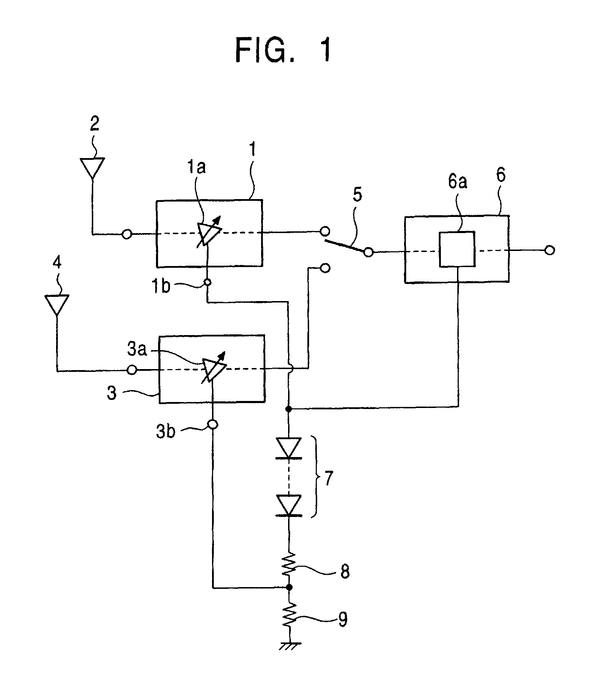

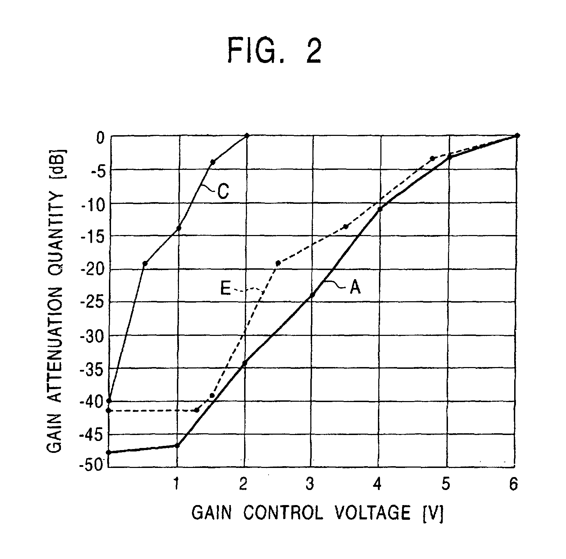

An automatic gain control apparatus according to an embodiment of the present invention will now be described with reference to Figs. 1 and 2. Here, Fig. 1 is a block diagram illustrating the construction of an automatic gain control apparatus of the present invention. Fig. 2 is a characteristic view illustrating gain control characteristics of the automatic gain control apparatus shown in Fig. 1.

First, referring to Fig. 1, a VHF tuner section 1, which is a first tuner section, is connected to a VHF antenna 2, and receives a digital audio broadcasting signal of a VHF band, which is a broadcast of a first frequency band, and outputs an intermediate-frequency signal IFv which is a first intermediate-frequency signal.

In a similar manner, a UHF tuner section 3, which is a second tuner section, is connected to a UHF antenna 4, and receives a digital audio broadcasting signal of a UHF band, which is a broadcast of a second frequency band, and outputs an intermediate-frequency signal IFu which is a second intermediate-frequency signal.

One of the intermediate-frequency signal IFv output from the VHF tuner section 1 and the intermediate-frequency signal IFu output from the UHF tuner section 3 is selected by a switch 5 and is input to an intermediate-frequency circuit section 6. The intermediate-frequency circuit section 6 comprises a gain control voltage generation circuit 6a, which generates a gain control voltage Vagc corresponding to the level of the input intermediate-frequency signal IFv or IFu. That is, when the level of the input intermediate-frequency signal IFv or IFu is very low or when neither the intermediate-frequency signal IFv nor IFu is input, a maximum gain control voltage Vmax (for example, 6 V) is generated, and the gain control voltage Vmax decreases with an increase in the level of the input intermediate-frequency signal IFv or IFu. A minimum value Vmin which is the minimum voltage of the gain control voltage Vagc output by the gain control voltage generation circuit 6a is usually about 1 to 1.2 V due to a residual voltage possessed by the gain control voltage generation circuit 6a itself.

The intermediate-frequency circuit section 6 comprises a demodulation circuit (not shown) which demodulates the intermediate-frequency signal IFv or IFu and outputs an audio signal A.

The VHF tuner section 1 comprises a tuning circuit (not shown) for selecting a digital audio broadcasting signal. which is desired to be received, from the input digital audio broadcasting signals of the VHF band, a first gain control amplifying circuit 1a, and a mixer (not shown). The selected digital audio broadcasting signal of the VHF band is frequency-converted into an intermediate-frequency signal IFv by the mixer. Furthermore, the VHF tuner section 1 comprises a gain control end 1b which is a first control end, so that the gain control voltage Vagc output from the intermediate-frequency circuit section 6 is input to this gain control end 1b, thereby controlling the gain of the first gain control amplifying circuit 1a.

In contrast, the UHF tuner section 3 comprises a tuning circuit (not shown) for selecting a digital audio broadcasting signal, which is desired to be received, from the input digital audio broadcasting signals of the UHF band, a second gain control amplifying circuit 3a, and a mixer (not shown). The selected digital audio broadcasting signal of the UHF band is frequency-converted into an intermediate-frequency signal IFu by the mixer. Furthermore, the UHF tuner section 3 comprises a gain control end 3b which is a second control end, so that the gain control voltage Vagc output from the intermediate-frequency circuit section 6 is input to this gain control end 3b, thereby controlling the gain of the second gain control amplifying circuit 3a.

As a result, the level of the intermediate-frequency signal IFv or IFu input to the intermediate-frequency circuit 6 is controlled so as to become nearly constant.

Here, referring to Fig. 2, a description is given of the gain control characteristics of the first gain control amplifying circuit 1a of the VHF tuner section 1 and the second gain control amplifying circuit 3a of the UHF tuner section 3. First, a curve A in Fig. 2 is the same as a curve A in Fig. 4 and shows the gain control characteristics of the first gain control amplifying circuit 1a of the VHF tuner section 1. The first gain control amplifying circuit 1a is designed in such a way that its maximum gain (the maximum gain is indicated by 0 dB as a reference) is obtained when the gain control voltage (horizontal axis) applied to the gain control end 1b is 6 V. The gain is attenuated as the gain control voltage is gradually decreased, and a gain of about 47 dB is attenuated when the gain control voltage is 1 V. The gain attenuation quantity barely changes under a gain control voltage of 1 V or less.

In contrast, the second gain control amplifying circuit 3a of the UHF tuner section 3 is designed in such a way that its maximum gain is obtained when the gain control voltage is 2 V, as shown by a curve B in Fig. 2. When the gain control voltage is 0 V, the gain attenuation becomes nearly 40 dB. The curve B in Fig. 2 is the same as the curve B in Fig. 4.

In a manner as described above, the gain control characteristics of the gain control amplifying circuit 1a of the VHF tuner section 1 are different from the gain control characteristics of the second gain control amplifying circuit 3a of the UHF tuner section 3, and the gain control voltage (2 V) of the second gain control amplifying circuit 3a of the UHF tuner section 3, which is required at the maximum gain time, is one-third of the gain control voltage (6 V) of the gain control amplifying circuit 1a of the VHF tuner section 1, which is required at the maximum gain time. Accordingly, the gain control voltage Vagc from the intermediate-frequency circuit 6 is divided and supplied to the gain control end 3b of the UHF tuner section 3.

More specifically, the gain control voltage Vagc is made to drop by nearly a fixed voltage by one or a plurality of diodes 7, which are semiconductor two-terminal elements, having rectification characteristics, after which the voltage is divided by a first resistor 8 and a second resistor 9 and is supplied to the gain control end 3b of the UHF tuner section 3. The magnitude of the voltage drop by the diode 7 is appropriately set by the number of diodes 7 so that it becomes a minimum value Vmin of the gain control voltage Vagc output by the gain control voltage generation circuit 6a of the intermediate-frequency circuit section 6.

For example, it is assumed that the minimum value Vmin of the gain control voltage Vagc output by the gain control voltage generation circuit 6a is 1.2 V, and that a voltage drop per diode 7 is 0.4 V. Therefore, the number of diodes 7 to be used is three.

Consequently, when the gain control voltage Vagc from the gain control voltage generator 6a is a maximum value Vmax (6 V), a voltage of 4.8 V is applied across the entirety of the resistors 8 and 9. Therefore, the first resistor 8 and the second resistor 9 are set so that the voltage of the connection point of the first resistor 8 and the second resistor 9 becomes 2 V.

In this state, when the gain control voltage from the gain control voltage generation circuit 6a is decreased and reaches a minimum value Vmin (1.2 V), this voltage almost becomes a voltage drop of the diode 7. Therefore, the voltage at the connection point of the diode 7 and the first resistor 8 becomes nearly 0 V, and the voltage of the second gain control end 3b of the UHF tuner section 3 becomes 0 V.

As a result, when the gain control voltage Vagc is a maximum value Vmax (6 V), a gain control voltage of 2 V is applied to the gain control end 3b of the UHF tuner section 3, and when the gain control voltage Vagc is a minimum value Vmin (1.2 V), a gain control voltage of 0 V is supplied to the gain control end 3b of the UHF tuner section 3. Therefore, the gain control characteristics of the second gain control amplifying circuit 3a of the UHF tuner section 3 are seemingly converted into characteristics such as those shown in a curve E in Fig. 4, a maximum gain is obtained when the gain control voltage Vagc is at a maximum value Vmax (6 V), and when the gain control voltage Vagc is at a minimum value Vmin (1.2 V), a maximum attenuation quantity (nearly 40 dB) is obtained. Therefore, it is possible for the respective gain control amplifying circuits to perform control from the maximum gain to the minimum gain in an effective varying range of the gain control voltage.

As described above, in the automatic gain control apparatus of the present invention, a gain control voltage is input to a voltage-division circuit formed of semiconductor two-terminal elements and a resistor, a voltage applied across both ends of the voltage-division circuit is applied to a first control end, and a voltage divided by the semiconductor two-terminal elements and the resistor is applied to a second control end. This makes it possible to control a first gain control amplifying circuit and a second gain control amplifying circuit from a maximum gain to a minimum gain in an effective varying range of the gain control voltage even if control voltages required to obtain the respective maximum gains of the first gain control amplifying circuit and the second gain control amplifying circuit which are provided are different, and further, even if the range of the gain control voltage from the gain control voltage generation circuit is limited by a residual voltage or the like of the gain control voltage generation circuit.

Furthermore, in the automatic gain control apparatus of the present invention, a resistor is formed of a first resistor and a second resistor, the second resistor is grounded, and a voltage applied across the second resistor is applied to a second control end. This makes it possible to control from a maximum gain to a minimum gain in an effective varying range of the gain control voltage by appropriately setting the resistance values of the first resistor and the second resistor even if the voltage values required for the first gain control amplifying circuit and the second gain control amplifying circuit to obtain their respective maximum gains are greatly different.

Furthermore, the automatic gain control apparatus of the present invention comprises a diode in which semiconductor two-terminal element are connected in series. This makes it possible to control from a maximum gain to a minimum gain in an effective varying range of the gain control voltage by connecting a plurality of diodes even if the voltage values required for the first gain control amplifying circuit and the second gain control amplifying circuit to obtain their respective maximum gains are greatly different.

Many different embodiments of the present invention may be constructed without departing from the spirit and scope of the present invention. It should be understood that the present invention is not limited to the specific embodiment described in this specification. To the contrary, the present invention is intended to cover various modifications and equivalent arrangements included within the spirit and scope of the invention as hereafter claimed. The scope of the following claims is to be accorded the broadest interpretation so as to encompass all such modifications, equivalent structures and functions.

## Claims

1. An automatic gain control apparatus comprising:
a first tuner section for receiving a broadcasting signal of a first frequency band and outputting a first intermediate-frequency signal;
a second tuner section for receiving a broadcasting signal of a second frequency band and outputting a second intermediate-frequency signal
wherein said first tuner section comprises a first gain control amplifying circuit having a first control end for amplifying said broadcasting signal of the first frequency band and for controlling the degree of amplification, said second tuner section comprises a second gain control amplifying circuit having a second control end for amplifying said broadcasting signal of the second frequency band and for controlling the degree of amplification,
**characterized in that** it further includes
a gain control voltage generation circuit to which said first intermediate-frequency signal or said second intermediate-frequency signal is selectively input and which generates a gain control voltage responsive to the intensity of the input first or second intermediate-frequency signal; and
a control voltage at which the gain of said first gain control amplifying circuit reaches a maximum is set to be higher than a control voltage at which the gain of said second gain control amplifying circuit reaches a maximum, said gain control voltage is input to a voltage-dividing circuit formed of semiconductor two-terminal elements and a resistor, said resistor is grounded, a voltage applied across both ends of said voltage-dividing circuit is applied to said first control end, and a voltage divided by said semiconductor two-terminal elements and said resistor is applied to said second control end.

2. An automatic gain control apparatus according to claim 1, wherein said resistor is formed of a first resistor and a second resistor, said second resistor is grounded, and a voltage applied across said second resistor is applied to said second control end.

3. An automatic gain control apparatus according to one of claims 1 and 2, wherein said semiconductor two-terminal elements are comprises of a plurality of diodes connected in series.

## Patentansprüche

1. Vorrichtung zur automatischen Verstärkungsregelimg aufweisend:
einen ersten Tuner-Abschnitt, welcher ein Rundfunksignal eines ersten Frequenzbandes empfängt und ein erstes Zwischenfrequenzsignal ausgibt;
einen zweiten Tuner-Abschnitt, welcher ein Rundfunksignal eines zweiten Frequenzbandes empfängt und ein zweites Zwischenfrequenzsignal ausgibt;
wobei der erste Tuner-Abschnitt eine erste Verstärkungsregelungs-Verstärkerschaltung mit einem ersten Steueranschluss zum Verstärken des Rundfunksignals des ersten Frequenzbandes und zum Steuern des Verstärkungsgrades aufweist, und der zweite Tuner-Abschnitt eine zweite Verstärkungsregelungs-Verstärkerschaltung mit einem zweiten Steueranschluss zum Verstärken des Rundfunksignals des zweiten Frequenzbandes und zum Steuern des Verstärkungsgrades aufweist,
**dadurch gekennzeichnet, dass**
sie weiter eine Verstärkungsregelungs-Spannungserzeugungsschaltung beinhaltet, der wahlweise das erste Zwischenfrequenzsignal oder das zweite Zwischenfrequenzsignal zugeführt wird und die, reagierend auf die Stärke des zugeführten ersten oder zweiten Zwischenfrequenzsignals, eine Verstärkungsregelungsspannung erzeugt; und
eine Steuerspannung, bei welcher die Verstärkung der ersten Verstärkungsregelungs-Verstärkerschaltung ein Maximum erreicht, auf einen größeren Wert festgelegt ist als eine Steuerspannung, bei welcher die Verstärkung der zweiten Verstärkungsregelungs-Verstärkerschaltung ein Maximum erreicht, die Verstärkungssteuerspannung einer Spannungsteilerschaltung zugeführt wird, die aus zwei Anschlüsse aufweisenden Halbleiterelementen und einem Widerstand bestehen, der Widerstand geerdet ist, eine über beiden Enden der Spannungsteilerschaltung anliegende Spannung dem ersten Steueranschluss zugeführt wird, und eine Spannung, die durch die zwei Anschlüsse aufweisenden Halbleiterelemente und den Widerstand geteilt wird, dem zweiten Steueranschluss zugeführt wird.

2. Vorrichtung zur automatischen Verstärkungsregelung nach Anspruch 1, bei welcher der Widerstand aus einem ersten Widerstand und einem zweiten Widerstand besteht, der zweite Widerstand geerdet ist und eine über dem zweiten Widerstand anliegende Spannung dem zweiten Steueranschluss zugeführt wird.

3. Vorrichtung zur automatischen Verstärkungsregelung nach einem der Ansprüche 1 oder 2, bei welcher die zwei Anschlüsse aufweisenden Halbleiterelemente aus einer Mehrzahl von in Reihe geschalteten Dioden bestehen.

## Revendications

1. Un appareil de commande automatique de gain comprenant:
une première section à syntoniseur pour recevoir un signal d'émission de la première bande de fréquence et pour émettre un premier signal de fréquence intermédiaire;
une deuxième section à syntoniseur pour recevoir un signal d'émission d'une deuxième bande de fréquence et pour émettre un deuxième signal de fréquence intermédiaire;
dans lequel la première section à syntoniseur comprend un circuit amplifiant de commande de gain ayant une première extrémité de commande pour amplifier le signal d'émission de la première bande de fréquence et pour contrôler le degré d'amplification, cette deuxième section à syntoniseur comprenant un deuxième circuit d'amplification de commande de gain ayant une deuxième extrémité de commande pour amplifier le signal d'émission de la deuxième bande de fréquence et pour contrôler le degré d'amplification, **caractérisé en ce qu**'il comporte de surcroît
un circuit de génération de tension dans lequel le premier signal de fréquence intermédiaire ou le deuxième signal de fréquence intermédiaire sont introduits sélectivement, et qui génère une tension de commande de gain réagissant à l'intensité de l'entrée du signal de première ou deuxième fréquence intermédiaire, et
une tension de contrôle, représentant celle quand le gain du premier circuit d'amplification atteint un maximum, est réglée pour être à une valeur plus élevée que la tension de contrôle à laquelle le gain du deuxième circuit d'amplification de commande de gain atteint un maximum, cette tension de commande de gain est introduite dans un circuit diviseur de tension, formé d'éléments semi-conducteurs à deux bornes et d'un résisteur, ce résisteur étant mis à la terre, une tension appliquée aux deux extrémités du circuit diviseur de tension est appliquée à la première extrémité de la commande et une tension divisée par les éléments à deux-bornes du semi-conducteur et par le résisteur est appliquée à la deuxième extrémité de commande.

2. Un appareil de commande automatique de gain selon la revendication 1, dans lequel le résisteur est formé d'un premier résisteur et d'un deuxième résisteur, ce deuxième résisteur est mis à la terre et un voltage appliqué au deuxième résisteur est appliqué à la deuxième extrémité de la commande.

3. Un appareil de commande automatique de gain selon l'une des revendications 1 et 2, dans lequel les éléments à deux bornes du semi-conducteur sont composés d'un nombre de diodes connectées en série.
